**Europäisches Patentamt**

**European Patent Office**

**Office européen des brevets**

(19)

(11) Numéro de publication: **0 140 793**
**B1**

(12) **FASCICULE DE BREVET EUROPEEN**

(45) Date de publication du fascicule du brevet:
**18.10.89**

(21) Numéro de dépôt: **84402166.7**

(22) Date de dépôt: **29.10.84**

(51) Int. Cl.⁴: **C 03 C 17/02, B 05 C 15/00**

(54) Procédé pour la préparation de vitrages munis de bandes filtrantes et dispositif pour la mise en oeuvre du procédé.

(30) Priorité: **29.10.83 DE 3339334**
**12.01.84 DE 3400843**

(43) Date de publication de la demande:
**08.05.85 Bulletin 85/19**

(45) Mention de la délivrance du brevet:
**18.10.89 Bulletin 89/42**

(84) Etats contractants désignés:
**BE DE FR GB IT NL SE**

(56) Documents cités:
**EP-A- 0 041 773**
**US-A- 2 702 760**
**US-A- 3 683 847**

**IBM TECHNICAL DISCLOSURE BULLETIN, vol. 13, no. 4, septembre 1970, pages 1035-1036, New York, US; T.M. BYRNE et al.: "Continuous parallel-plate RF sputtering system"**

(73) Titulaire: **SAINT-GOBAIN VITRAGE, "Les Miroirs" 18, avenue d'Alsace, F-92400 Courbevoie (FR)**

(84) Etats contractants désignés: **BE FR GB IT NL SE**

(73) Titulaire: **VEGLA Vereinigte Glaswerke GmbH, Viktoriaallee 3-5, D-5100 Aachen (DE)**

(84) Etats contractants désignés: **DE**

(72) Inventeur: **Roth, Mario, Laurenstiusstrasse 13, D-5100 Aachen (DE)**
Inventeur: **Termath, Günther, Pannhütte 58, D-4650 Gelsenkirchen (DE)**

(74) Mandataire: **Muller, René et al, SAINT-GOBAIN RECHERCHE 39, quai Lucien Lefranc, F-93304 Aubervilliers (FR)**

ACTORUM AG

## Description

La présente invention concerne la préparation d'un vitrage présentant, le long de l'un au moins de ses bords, destiné par exemple à constituer le bord périphérique supérieur d'un vitrage pour véhicules automobiles, ou le long de ses bords supérieur et inférieur, une bande filtrante. La présence de ces bandes filtrantes confère au vitrage des caractéristiques d'absorption et/ou de réflexion accrues dans le domaine visible du spectre. Un procédé utilisé pour la formation des bandes peut être par exemple un procédé chimique de décomposition pyrolytique, un procédé d'évaporation thermique ou encore de pulvérisation cathodique.

On sait déposer, en continu, des couches sur un support. Ainsi, le brevet européen EP-A-41 773 décrit un procédé pour obtenir en continu des cellules solaires comprenant plusieurs couches de substances semi-conductrices amorphes de conductivité différente. Il consiste à faire passer un substrat, en continu, dans plusieurs enceintes successives, chacune de ces enceintes servant à déposer, sur le substrat, par décharge luminescente, une couche de substance semi-conductrice différente. Ces enceintes sont séparées les unes des autres, pour éviter le mélange des constituants gazeux servant au dépôt.

On connaît déjà des vitrages pour véhicules automobiles qui présentent des bandes filtrantes de protection contre l'éblouissement le long de leur bord périphérique supérieur. Usuellement, lorsque le vitrage est un vitrage feuilleté classique, c'est-à-dire comprenant une feuille thermoplastique entre deux feuilles de verre individuelles, on teint la feuille intercalaire thermoplastique ou on l'imprime avec une couche de couleur convenable. De telles bandes filtrantes fonctionnent de façon satisfaisante comme protection contre les longueurs d'onde du domaine visible. Toutefois, on constate un degré insuffisant de réflexion dans le domaine infrarouge.

On connaît également des moyens pour appliquer une bande filtrante le long du bord périphérique supérieur du vitrage lui-même. On a utilisé pour ce faire une multitude de procédés. Par exemple, on peut appliquer la bande filtrante sous vide par évaporation thermique, ou encore par pulvérisation cathodique. De telles bandes, appliquées sur la surface du vitrage, lui confèrent des caractéristiques d'absorption et de réflexion satisfaisantes, même dans le domaine infrarouge.

Suivant une technique connue, en application de laquelle la bande filtrante est déposée sous vide, on découpe dans de grandes feuilles de verre, les feuilles de verre destinées à former des vitrages feuilletés à leurs dimensions finales désirées, puis on applique une bande filtrante sur l'une de ces feuilles de verre. On soumet éventuellement les feuilles à un bombage, à la suite duquel on dépose entre deux feuilles de verre une feuille intercalaire thermoplastique pour assurer leur adhérence. Mais un tel procédé est particulièrement coûteux et peu économique, car il oblige lors du dépôt des bandes à un traitement individuel de chaque feuille de verre, ce qui accroît encore les dépenses nécessaires à l'opération.

La présente invention vise à proposer un procédé qui ne présente pas les inconvénients précités, en particulier pour la préparation d'un vitrage ayant une bande filtrante supérieure, ou à la fois une bande filtrante supérieure et inférieure.

Suivant l'invention, on crée un mouvement relatif continu entre un panneau de verre de grandes dimensions et un dispositif de dépôt de couches, la taille dudit panneau de verre étant telle qu'il puisse être séparé en ébauches à partir desquelles seront découpées des vitrages au contour déterminé, on dépose un matériau de revêtement sous la forme de bandes filtrantes placées les unes à côté des autres et s'étendant continûment dans une direction le long du panneau de verre, puis on sépare le panneau en faisant en sorte que chaque ébauche découpée présente une bande filtrante sur au moins l'un de ses bords périphériques.

Le panneau de verre présente ainsi des bandes périphériques et des bandes intermédiaires.

Suivant un aspect de l'invention, les bandes filtrantes sont espacées, et d'une largeur déterminée à l'avance, de façon à ce que chaque segment du panneau de verre obtenu après une découpe longitudinale présentent au moins une portion desdites bandes filtrantes. Chacune de ces portions de bandes filtrantes constituera ultérieurement une bande filtrante supérieure et/ou inférieure pour le vitrage.

Conformément à cet aspect de l'invention, les bandes filtrantes situées entre les bandes périphériques sont d'une largeur déterminées à l'avance, qui peut être environ deux fois la largeur des bandes périphériques et au moins environ deux fois la largeur d'une bande filtrante telle qu'elle apparaît finalement sur un vitrage. Ainsi, lorsqu'on découpe le panneau de verre par sa longueur, on fait passer la ligne de découpe dans la largeur d'une bande filtrante, et l'épaisseur des portions de ladite bande qui restent sur chacun des segments de verre découpés convient pour l'application souhaitée comme bande filtrante d'un vitrage.

Suivant un autre aspect de l'invention, les bandes non périphériques peuvent avoir une largeur sensiblement identique, mais être espacées de façon à ce que les segments de verre issus d'une découpe longitudinale du panneau ne comportent qu'une seule bande filtrante.

Conformément à l'un ou l'autre des aspects de l'invention indiqués, le vitrage découpé à partir de l'ébauche comprendra une bande filtrante supérieure et inférieure, ou uniquement une bande filtrante supérieure.

Les bandes filtrantes peuvent, selon l'invention, s'étendre suivant une trajectoire rectiligne ou se présenter comme une succession de sections de courbes, ou encore comme une courbe sinusoïdale. Toute autre forme pourrait également être envisagée.

Dans le cas de la préparation d'un pare-brise pour véhicules automobiles, on peut envisager une forme de bandes filtrantes convenant particulièrement. De façon courante, un vitrage convenant comme pare-brise présente un bord périphérique supérieur et inférieur non rectiligne. Il peut dont être avantageux de former une bande filtrante qui s'étende dans la zone périphérique supérieure du vitrage, et éventuellement dans la zone périphérique inférieure, et dont le bord, définissant la limite entre la bande filtrante et le champ de vision du vitrage, soit parallèle au bord périphérique du vitrage. Pour obtenir un vitrage présentant de telles bandes, on peut utiliser, parmi les formes de bandes filtrantes continues précédemment indiquées, celles qui sont des successions de sections en forme d'arc ou des courbes sinusoïdales.

Toutefois, il peut être souhaitable que le bord de la bande qui fixe la limite avec le champ de vision ne soit pas parallèle au bord périphérique du vitrage. On peut par exemple abaisser la ligne de démarcation de la bande inférieure aux extrémités du vitrage. Une telle forme de bande présente des caractéristiques esthétiques moindres que lorsque la ligne de démarcation suit la périphérie du vitrage, mais elle accroît le champ de vision en bas du pare-brise et elle permet une meilleure visibilité sur les côtés de la route.

L'invention permet donc de fabriquer un vitrage qui présente une bande filtrante supérieure avec une ligne de démarcation qui suit le bord périphérique du vitrage et une bande filtrante inférieure dont la ligne de démarcation s'abaisse sur les côtés. L'esthétisme est préservé dans une telle structure, au moins dans la zone supérieure où la bande est plus visible; et on peut obtenir une meilleure visibilité sur les côtés.

L'invention concerne également un dispositif pour la mise en œuvre du procédé. Un dispositif convenable comprend une installation de pulvérisation cathodique constituée d'une enceinte dans laquelle se trouve une cathode-source pour le dépôt de couches par condensation de matière sur une feuille de verre en mouvement en dessous de la cathode. Suivant les variantes de l'invention, la cathode peut être fixe pendant le dépôt ou mobile suivant un mouvement de va-et-vient déterminé à l'avance transversalement à la direction de déplacement de la feuille de verre. Par la régulation de ce mouvement, on peut déposer sur la feuille de verre des séries de bandes dont la trajectoire est rectiligne, ou sinusoïdale, par exemple. Pour ajuster la largeur de l'une quelconque des bandes, on peut associer à la cathode un système d'écrans. La combinaison du mouvement de la cathode et de l'écran permet la formation de bandes pouvant avoir toutes les allures souhaitées suivant le contour du vitrage lui-même.

Le procédé selon l'invention peut être mis en œuvre sur des feuilles de verre de silicate, mais également sur des plaques ou des feuilles de toute matière transparente pouvant être utilisée comme vitrage pour véhicules automobiles. Si la feuille est en matière plastique, il faut qu'elle soit exempte de solvant et de plastifiant. Par ailleurs, il est possible, par exemple, de recouvrir de bandes non pas la feuille de verre de silicate elle-même, mais une feuille adhésive intervenant dans la fabrication d'un vitrage feuilleté, par exemple en un matériau thermoplastique. Il faut simplement que la feuille réponde aux conditions indiquées ci-dessus. On peut citer par exemple un polyuréthane thermoplastique.

D'autres caractéristiques et avantages de l'invention apparaîtront au cours de la description détaillée suivante de différents modes de réalisation, en relation avec les figures annexées 1 à 14, parmi lesquelles:

– les figures 1 à 4 représentent un panneau de verre ou feuille de verre de grandes dimensions recouvert de bandes continues sur la plus grande dimension de la feuille, et sur laquelle apparaissent les lignes de séparation entre les ébauches à partir desquelles seront découpés les vitrages aux dimensions finales souhaitées.

– la figure 5 est une vue en coupe d'un vitrage feuilleté dont l'une des feuilles de verre est recouverte d'après le procédé selon l'invention.

– la figure 6 représente une coupe verticale d'un dispositif en continu à plusieurs enceintes pour la mise en œuvre d'un procédé de pulvérisation cathodique appliqué à l'invention.

– la figure 7 est un exemple de disposition des cathodes de pulvérisation dans une enceinte de dépôt pour un fonctionnement en continu.

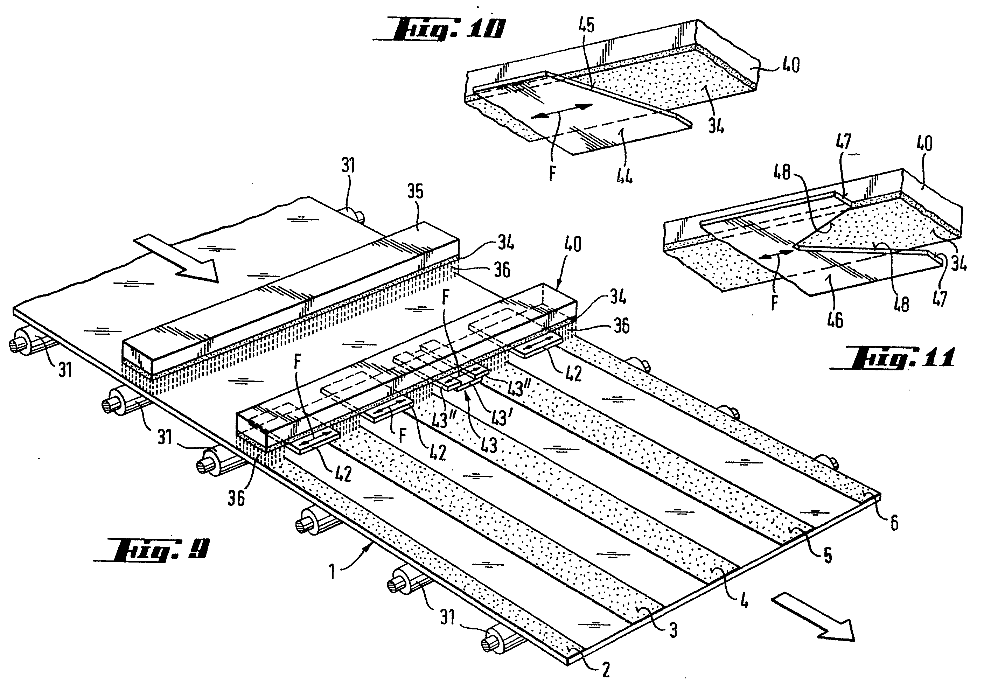

– là figure 8 est une vue en perspective d'une cathode légèrement modifiée.

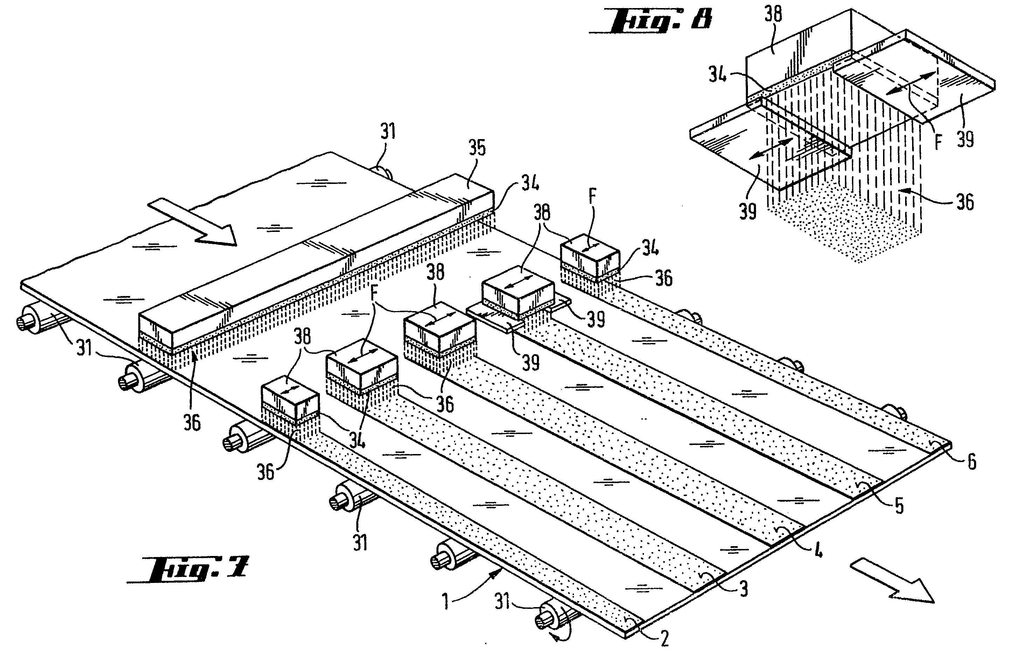

– la figure 9 est une vue analogue à la figure 7 illustrant une forme légèrement modifiée de cathode.

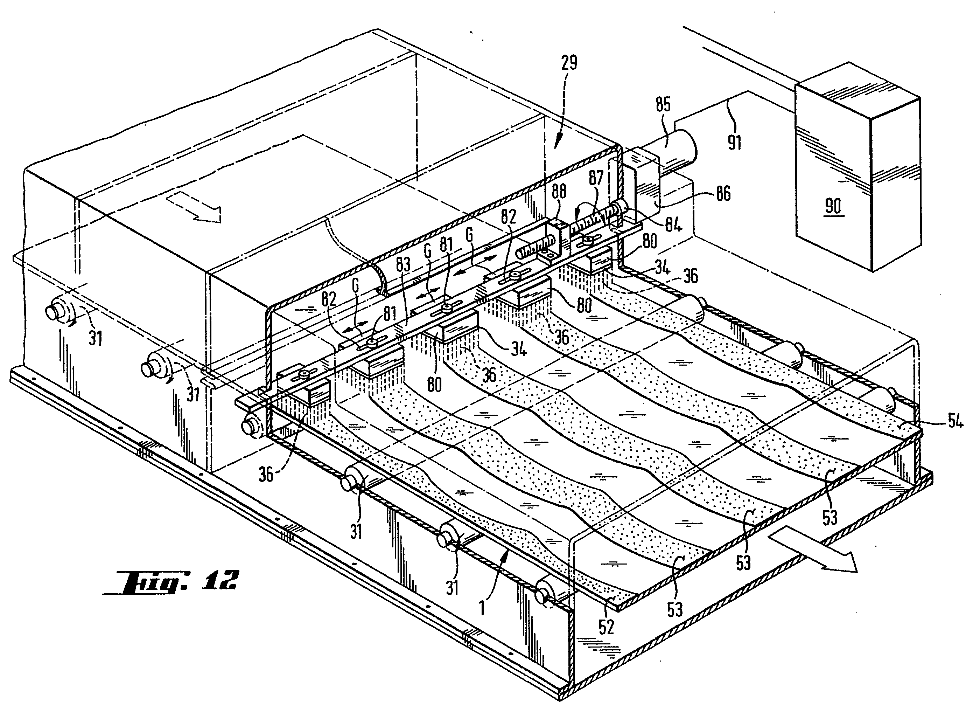

– les figures 10 et 11 sont des vues en perspective d'une cathode de pulvérisation comprenant un écran disposé en dessous de la cathode pour former une bande filtrante d'épaisseur variable.

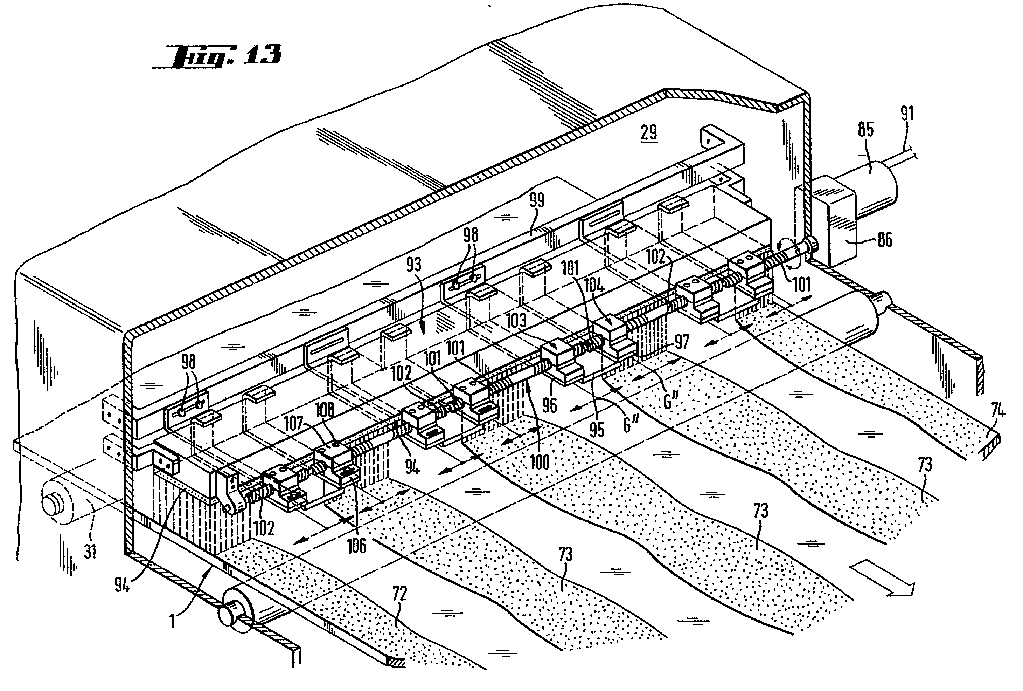

– la figure 12 est une vue analogue aux vues 7 et 9, qui illustre le cas où la pluralité de bandes déposées sur le vitrage est d'une largeur constante.

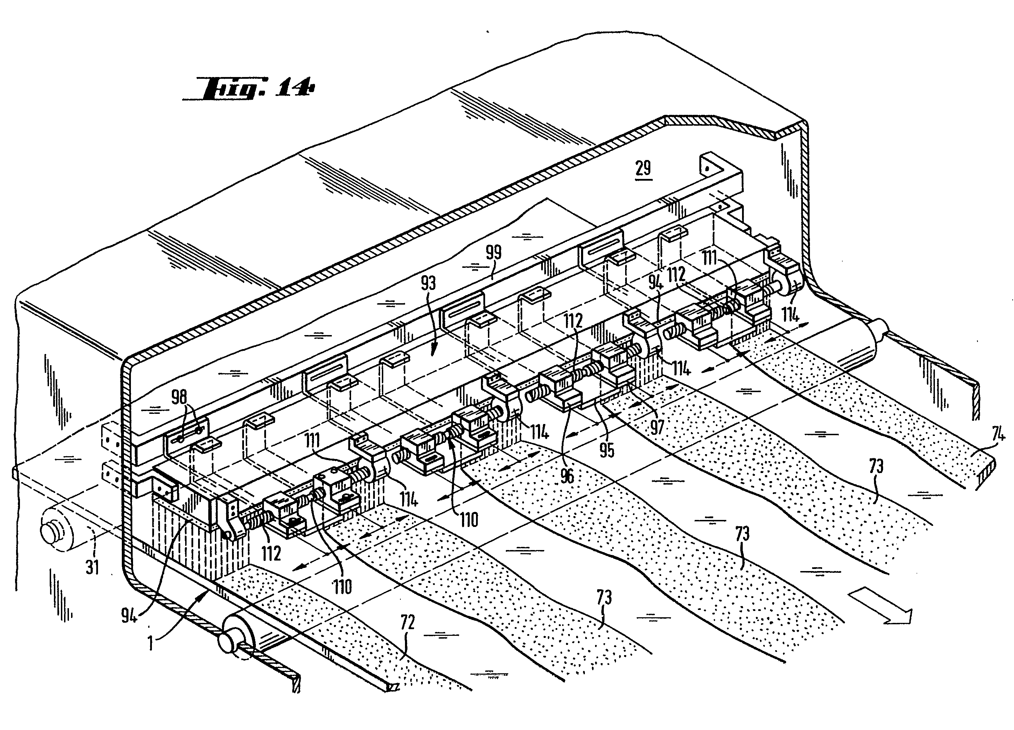

– les figures 13 et 14 sont des vues analogues aux figures 7, 9 et 12 qui illustrent des cas où la pluralité de bandes déposées sur le vitrage est de largeur variable.

On se place à la sortie d'un dispositif de fabrication de verre par la technique du verre flotté, qui délivre des feuilles de verre dont les dimensions standard sont de 6 mètres de long environ et de plus de trois mètres de large.

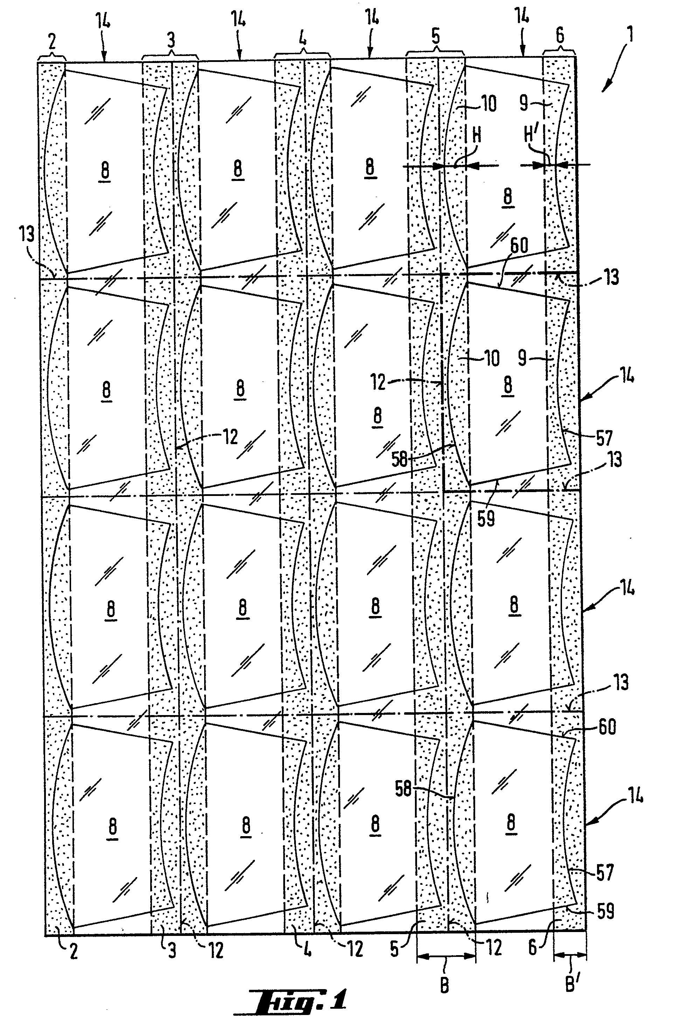

On a représenté figure 1, une feuille 1 ayant ces dimensions. La totalité de la feuille est soumise à un traitement conduisant au recouvrement de la surface du verre par des bandes, de sorte qu'à la fin du traitement, la feuille présente toute une série de bandes filtrantes longitudinales 2, 3, 4, 5, 6 lesquelles présentent les propriétés souhaitées de réflexion et d'absorption. La distance respective des bandes 2 à 6, ainsi que leur largeur B ou B′ sont déterminées d'après la taille et la forme des vitrages 8 qui doivent être découpées à partir d'ébauches 14 découpées elles-mêmes dans la feuille de verre 1. Dans l'exemple représenté à la figure 1, les vitrages 8 ont la taille et la forme de pare-brise. Par ailleurs, la largeur B ou B' des bandes dépend de la hauteur H ou H' qui doivent présenter respectivement la bande filtrante supérieure 9 ou inférieure 10 sur les ébauches. Il est donc nécessaire d'établir au préalable, en fonction des paramètres cités, la largeur et la position des bandes filtrantes 2 à 6, sur la feuille de verre 1, et de fixer corrélativement les conditions opératoires du procédé de dépôt desdites bandes.

Le rôle de la ou des bandes ainsi déposée(s) est de conférer au vitrage 8 les propriétés désirées de réflexion et d'absorption.

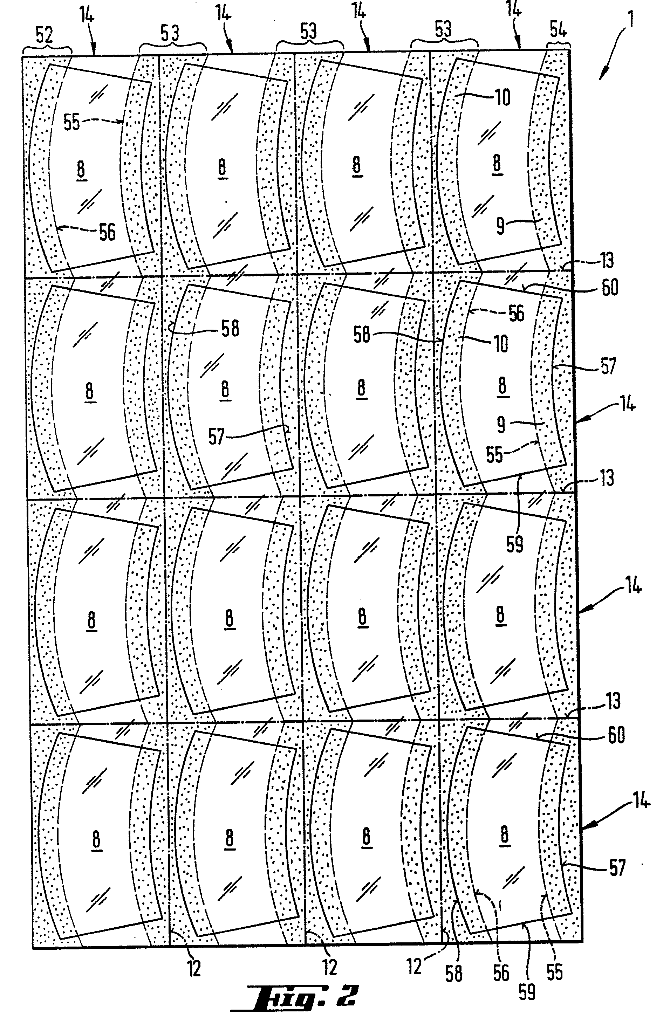

Les figures 2 à 4 représentent une feuille de verre 1 sur laquelle ont été déposées des bandes filtrantes d'aspect un peu différent. Sur la figure 2, les bandes 52 et 54 sont situées le long des bords périphériques de la feuille de verre, et une pluralité de bandes 53 sont déposées entre elles à intervalles réguliers. L'allure de ces bandes est une succession d'arcs de sinusoïde. Plus particulièrement, chaque courbe commence à un bord de la feuille de verre 1 (un bord de la plus petite dimension) et se reproduit périodiquement à chaque ligne 13, qui est une ligne séparant sur toute sa longueur la feuille de verre en segments parallèles. Chaque bande filtrante 53 a une largeur constante sur toute sa longueur. La courbure de l'arc sinusoïdal est choisie de façon à ce que les lignes 55, 56 qui délimitent les bandes filtrantes 9 et 10 du côté adjacent au champ de vision du vitrage suivent les bords correspondants 57, 58 du vitrage 8. En particulier, la bande supérieure 9, et la bande inférieure 10, s'il y en a une, s'étend parallèlement aux bords 57, 58 du vitrage. Pour cela, les bandes filtrantes sont de préférence de largeur constante.

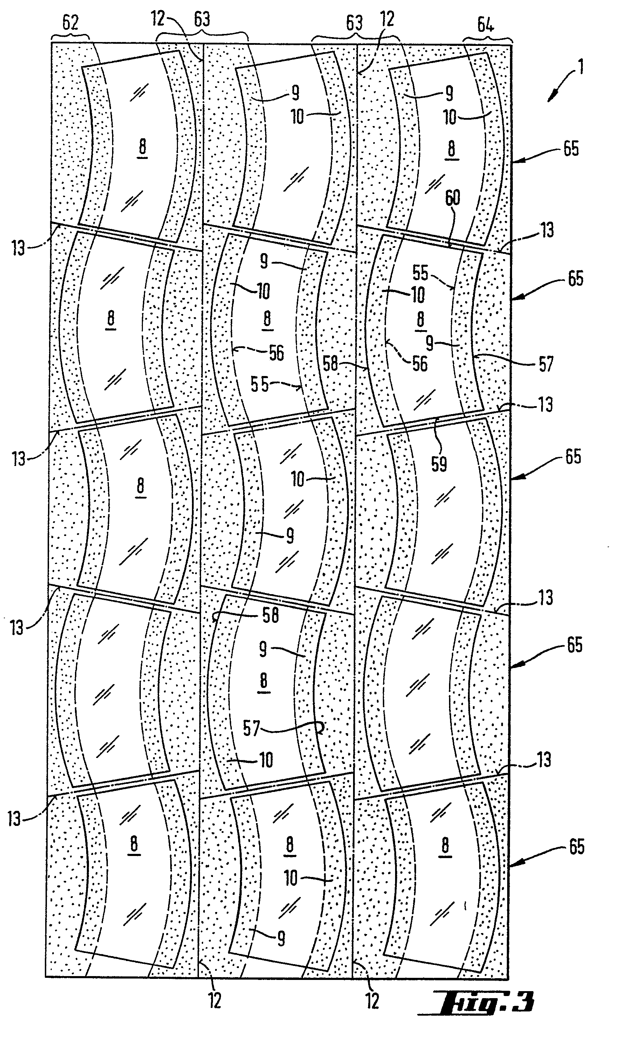

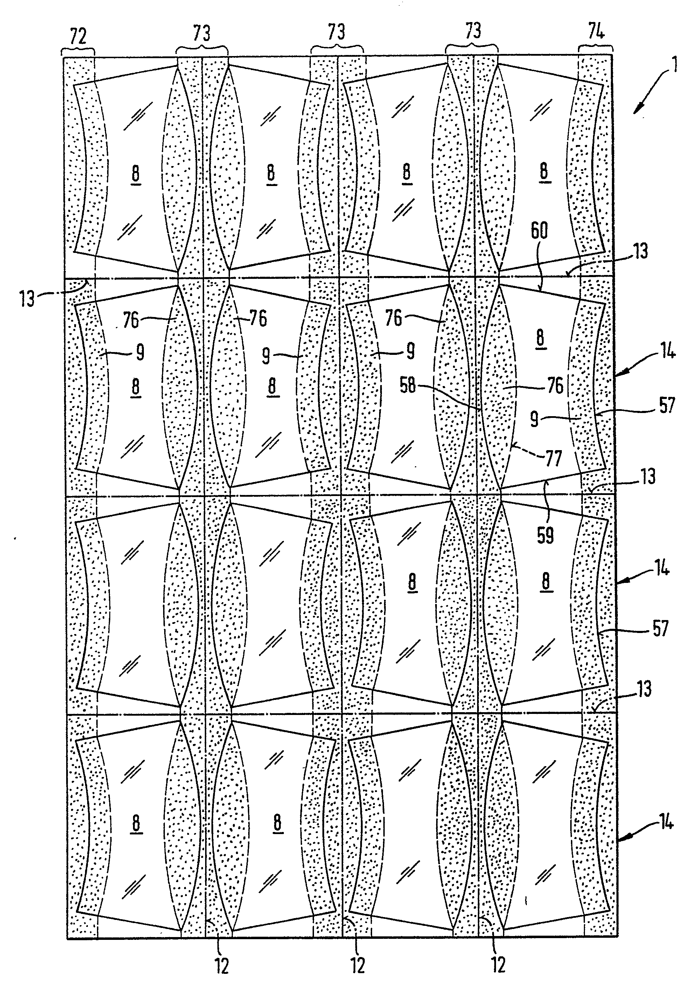

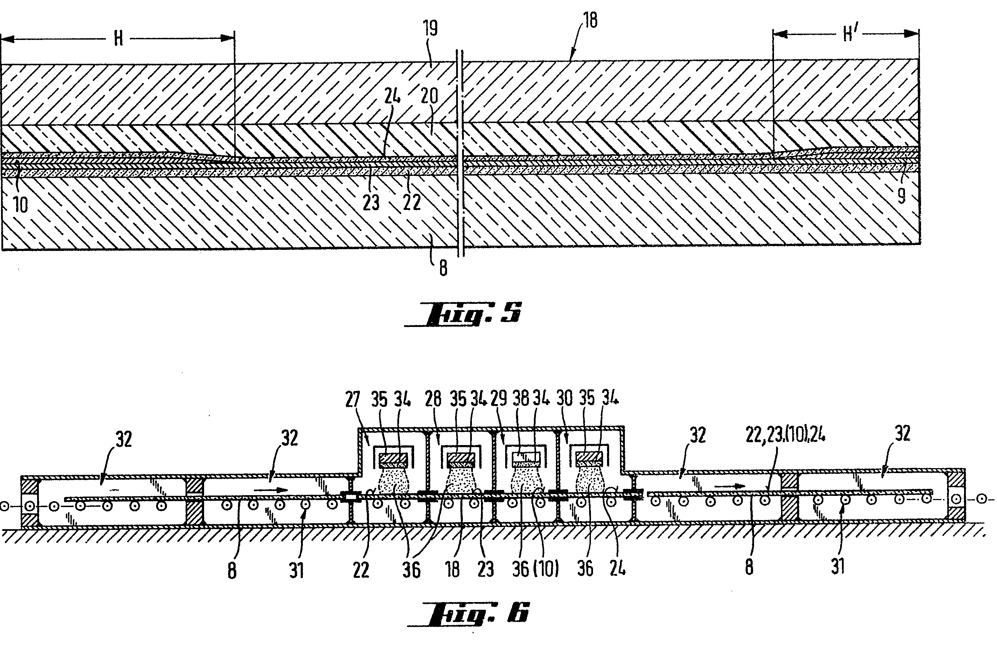

La figure 3 illustre un type de bande filtrante dont l'allure est celle d'une sinusoïdale complète, ou d'une autre courbe analogue. Les bandes filtrantes comprennent des bandes 62, 63 et 64, disposées de telle façon que les bandes 62 et 64 sont le long des bords périphériques de la feuille de verre 1, et les bandes 63 sont entre lesdites bandes 62 et 64.

La feuille de verre 1 de la figure 3 se différencie de celle des figures 1 et 2 dans la mesure où les ébauches 65 ont une forme trapézoïdale et non plus rectangulaire, et dans la mesure où les bords longitudinaux 57 et 58 des vitrages 8 découpés dans les ébauches 65, suivent l'allure de la courbe décrite par les bandes filtrantes. Comme cela apparaît figure 3, les vitrages 8 sont placés les uns à côté des autres, dans la direction de plus grande dimension de la feuille de verre 1, en alternance. En d'autres termes, les vitrages adjacents sont retournés de 180° autour d'un axe passant entre leur bord supérieur et inférieur.

Chacune des bandes 63 a une largeur constante sur toute sa longueur. En outre, les lignes 55, 56 qui délimitent les bandes supérieures 9 et inférieures 10 par rapport au champ de vision du vitrage suivent le profil des bords 57 et 58 du vitrage 8.

La feuille de verre 1 des figures 1, 2 et 4 comme cela sera décrit ultérieurement, est séparée puis découpée en une pluralité d'ébauches rectangulaires 14. Cette séparation se fait suivant un ensemble de lignes parallèles 12 (dans la direction de plus grande dimension de la feuille de verre 1) et un ensemble de lignes parallèles 13 (dans la direction de plus petite dimension) perpendiculaires aux précédentes. Dans chaque ébauche, on définit un pourtour 57, 58, 59, 60 (figures 2 à 4) correspondant à un vitrage 8, on casse ou découpe la feuille de verre 1 dans une direction longitudinale le long des lignes 12, puis chaque segment ainsi constitué est découpé suivant les lignes 13. Les lignes de découpe 12, 13 peuvent être amorcées dans la feuille de verre 1 à tout moment. Ensuite on découpe dans les ébauches 14 les vitrages individuels 8.

Dans le cas illustré par la figure 3, la feuille de verre 1 est d'abord découpée en ébauches 65 de forme trapézoïdale. A cette fin, on amorce des lignes de découpe 12 et on découpe la feuille 1 en segments suivant lesdites lignes de découpe. On amorce ensuite des lignes 13 sur chaque segment et la découpe le long desdites lignes conduit à l'obtention d'ébauches trapézoïdales 65. Ces ébauches trapézoïdales 65 servent à la découpe aux dimensions désirées des vitrages 8 suivant la circonférence 57, 58, 59, 60.

La figure 4 illustre une pluralité de bandes filtrantes 72, 73, 74. Les bandes 73 sont à égale distance les unes des autres, distance comptée sur la plus petite dimension de la feuille de verre 1. La forme des bandes est telle que chaque vitrage 8 présente une bande filtrante supérieure 9, qui est identique aux bandes filtrantes également référencées 9 sur les figures 2 et 3, et une bande filtrante inférieure 76. L'épaisseur de la bande inférieure va en diminuant vers les bords latéraux du vitrage 8, en partant d'une largeur maximale au niveau du plan médian dudit vitrage 8. Par conséquent, la ligne 77 qui délimite la bande inférieure ne suit pas le tracé du bord périphérique du vitrage 8. L'amincissement de la bande 76 permet d'augmenter les facultés de l'automobiliste pour discerner les limites latérales de la route; de surcroît, la largeur plus grande de la bande filtrante vers le centre du vitrage permet de réduire considérablement les effets de réflexion des rayons lumineux en provenance du capot du véhicule. Cette variante dans la forme des bandes filtrantes peut être particulièrement utile la nuit. Des formes de réalisation différentes des bandes filtrantes 9 et 76 procurent de meilleures propriétés de protection contre l'éblouissement.

Les bandes filtrantes 2, 3,..., 6 (fig. 1), 52, 53, 54 (fig. 2), 62, 64, (fig. 3) et 72, 73, 74 (fig. 4) peuvent être appliquées suivant différents procédés comme la décomposition par pyrolyse de composés métalliques, notamment organométalliques. Un tel procédé présente l'avantage de pouvoir être mis en œuvre directement sur un ruban de verre produit par la technique du verre flotté, avant même la découpe du ruban en feuille de verre de grandes dimensions.

Mais de préférence, les bandes filtrantes sont déposées sous vide, et, de façon particulièrement avantageuse, à l'aide d'un dispositif de pulvérisation cathodique. C'est pourquoi on décrira ci-après un mode détaillé de réalisation de l'invention à l'aide d'un tel dispositif.

Les bandes filtrantes sont appliquées de telle sorte que leur capacité et leur facteur d'absorption dans la gamme du visible décroissent continuement depuis le bord périphérique du vitrage jusqu'au champ de vision. Par conséquent, la capacité de transmission dans le domaine du visible augmente parallèlement de façon continue; on crée ainsi une transition douce entre les deux zones optiques, et le passage de l'une à l'autre n'engendre aucune perturbation de la vision.

En se référant à la figure 5, on voit comment une feuille de verre 8 peut être utilisée pour former un vitrage feuilleté 18. Un tel vitrage feuilleté se compose d'une feuille de verre 8 et d'une feuille de verre 19, assemblées à l'aide d'une feuille intercalaire thermoplastique 20, par exemple une feuille de polyvinylbutyral, par action de la température et de la pression. La feuille de verre 8 est revêtue par au moins une bande filtrante supérieure 9, et la feuille de verre 19 n'est pas revêtue.

Dans la variante plus précisément illustrée à la figure 5, la feuille de verre 8 est garnie d'une bande filtrante supérieure 9 et d'une bande filtrante inférieure 10, de largeur respective H' et H. La coupe de la figure 5 a été faite à partir de la figure 1, c'est pourquoi la largeur de la bande inférieure 10 est plus grande que celle de la bande supérieure 9. La feuille de verre 8 est revêtue d'autres couches qui contribuent à l'obtention d'un vitrage feuilleté qui présente des propriétés particulièrement intéressantes. On a ainsi représenté figure 5 une couche protectrice 24 disposée par-dessus les bandes filtrantes 9 et 10, sur toute la surface du vitrage. Une couche d'ancrage 22 est disposée directement sur la surface nue de la feuille de verre, et une couche métallique 23 qui réfléchit les rayonnements infrarouge est déposée par-dessus la couche 22, avant le dépôt des bandes filtrantes.

La couche 22 se compose de préférence d'un composé métallique ou semi-conducteur, en particulier d'oxyde de zinc, d'oxyde de zinc et d'indium, d'oxyde de titane, de nitrure de titane ou de sulfure de zinc, et a une épaisseur de 300 à 600 Angström. La couche métallique 23 est par exemple une couche d'argent, d'aluminium, de chrome, de fer, d'or de cuivre, ou éventuellement un mélange ou un alliage de ces métaux, éventuellement même, en combinaison avec d'autres. Cette couche métallique 23 a une épaisseur de 100 à 250 Angström environ. La couche 24 de protection peut avoir la même composition que la couche d'ancrage 22. L'épaisseur des bandes filtrantes dont la nature est analogue à celle de la couche métallique 23, est choisie de façon à ce que, en conjonction avec la couche métallique 23, on obtienne les propriétés d'absorption, et donc les propriétés anti-éblouissantes désirées.

En vue de l'utilisation du vitrage feuilleté 18 comme pare-brise de véhicule automobile, on oriente le vitrage de façon à ce que les bandes 9 et 10 soient dirigées vers l'extérieur du véhicule. C'est suivant cette disposition que les bandes montreront la meilleure capacité de réflexion. Comme indiqué précédemment, la largeur de la bande 10 est supérieure à celle de la bande 9. En outre, l'épaisseur de chaque bande filtrante diminue depuis la périphérie en direction du centre. Cette diminution se fait par un changement de pente, lequel peut être obtenu à l'aide des dispositifs représentés figure 10 et 11.

De tels systèmes de couches, en combinaison avec les bandes filtrantes 9 et 10, sont particulièrement avantageux car les vitrages feuilletés obtenus se prêtent au chauffage électrique des véhicules. Ceci est particulièrement vrai lorsque les bandes filtrantes présentent une bonne conductivité électrique, et quand la couche métallique 23 présente elle-même également une conductivité électrique élevée. En effet, les vitrages ayant une telle structure peuvent fonctionner avec une tension électrique plus faible que celle nécessaire avec les vitrages non revêtus de telles couches conductrices.

On a indiqué, figure 6 et suivantes, un dispositif de pulvérisation cathodique en continu.

Le dispositif représenté est un système de pulvérisation cathodique à magnétron à haut rendement. Il se compose d'un bâti divisé en canaux sous vide, comprenant des enceintes de dépôt 27, 28, 29, 30 dans lesquelles sont amenées, grâce à un convoyeur 31, les feuilles de verre à recouvrir. Les enceintes sont ouvertes ou fermées par un système d'écluses 32. On dépose par exemple la couche d'ancrage 22 dans l'enceinte 27, la couche métallique 23 dans l'enceinte 28, les bandes 2, 3, ..., 6 (ou celles représentées figures 2 à 4) dans l'enceinte 29, et la couche de protection 24 dans l'enceinte 30.

Le dépôt des différentes couches se fait dans chaque enceinte de façon sensiblement identique. A cette fin, chacune des enceintes 27, 28, 30 comprend une cathode 35 qui s'étend d'un bout à l'autre de l'enceinte (figures 7 et 9). Une plaque 34 est attachée à la surface inférieure de la cathode. La cathode et la plaque, également dénommée cible sont toujours superposées et elles s'étendent sur une largeur de 3 mètres ou plus, de toutes façons au moins égale à la plus petite dimension de la feuille de verre 1. Le matériau à pulvériser est amené depuis l'ensemble cathode-cible jusqu'à la surface à revêtir sous la forme de nuages 36 qui se condensent sur la surface du verre et y forment la couche homogène désirée sur toute la largeur de la feuille de verre 1. Par contre, pour déposer des bandes telles que 2, 3, ..., 6, on utilise des cathodes 38 en nombre égal au nombre de bandes à former. Les cathodes 38, de dimension réduite, sont montées sur une structure non représentée de façon à être mobiles latéralement par rapport à la direction du mouvement de la feuille de verre 1. Leur mouvement est indiqué par la double flèche F.

D'autres dispositions et formes de cathodes vont maintenant être décrites.

En référence avec les figures 4 et 5, on va décrire une structure de cathode convenant pour modifier la largeur d'une bande filtrante. A cette fin, on met en place, en dessous des cathodes 38, un écran ou une paire d'écrans 39, mobiles dans la direction indiquée par la double flèche F. On peut monter ces écrans de la façon souhaitée, pourvu qu'elle permette d'obturer les extrémités des cathodes 38 ou des cibles 34 dans la mesure souhaitée pour obtenir des bandes de la largeur voulue. Une seule paire d'écrans a été représentée sur la figure pour des raisons de simplification.

On a représenté figure 9 une cathode unique 40 qui, bien que s'étendant sur toute la largeur de la feuille de verre 1, permet la formation de bandes telles que les bandes filtrantes 2, 3, ..., 6. Dans cette variante, pour que les parties de la feuille de verre qui ne doivent pas être recouvertes des bandes filtrantes ne soient effectivement pas recouvertes, on a disposé des écrans 42 en dessous de la cathode 40. Chaque écran est monté, de façon non représentée, afin que sa position relative par rapport à la feuille de verre 1 puisse varier dans la direction indiquée par la double flèche F.

Si on souhaite en outre pouvoir modifier la largeur des bandes, en plus de leur position relative sur la feuille de verre, il convient d'utiliser un écran 43 en plusieurs parties. Un tel écran est constitué d'une plaque centrale 43′ et de deux plaques latérales 43″, mobiles dans la direction indiquée par la double flèche F.

Les plaques latérales 43″ se trouvent au-dessus ou en dessous des plaques centrales 43′ et la recouvrent, de sorte que quand on déplace les plaques 43″, la largeur efficace de l'écran 43 est modifiée.

Lors de la description de la figure 5, on a fait référence à la rupture de pente conduisant à une diminution progressive de l'épaisseur des bandes filtrantes. La forme des écrans 39, 42 ou 43 peut intervenir pour conduire à la modification d'épaisseur souhaitée. Par exemple, l'écran 44 représenté à la figure 10 présente un bord biseauté 45 de telle façon qu'il existe un angle aigu entre ledit bord et la direction du mouvement que peut prendre l'écran, symbolisé par la flèche F. Par conséquent, l'écran a pour rôle de limiter la surface efficace de la cathode 40, ou de la cible 34, cette surface diminuant de façon continue jusqu'à une zone où toute la surface est recouverte par l'écran. L'écran 46 représenté à la figure 11 qui présente une échancrure 48 en forme d'angle sur son bord périphérique 47 joue le même rôle.

On se réfère maintenant aux figures 12 à 14 qui illustrent un dispositif de pulvérisation particulièrement adapté pour la formation des bandes filtrantes des figures 2 à 4.

On a représenté figure 12 une partie de l'enceinte 29 et de la feuille de verre 1 mise en mouvement dans la direction indiquée par les flèches à l'aide des rouleaux 31. La vitesse à laquelle se déplace la feuille de verre à travers l'enceinte 29 est contrôlée, de même que celle à laquelle elle se déplace dans les autres chambres (non représentées sur la figure 12 car décrites en relation avec la figure 6).

Plusieurs cathodes individuelles 80, avec des plaques 34 disposées rigoureusement dans le plan des cathodes et montées à leur base pour servir de cibles, sont utilisées pour former les bandes 52, 53 et 54 sur la feuille de verre 1. La largeur efficace de chaque cathode correspond à celle de la bande que l'on souhaite former. La largeur de chaque dépôt de matière effectué peut être contrôlée par l'utilisation d'un écran, tels que les écrans 39, 42, 43 précédemment décrits. Un nuage de matière référencé 36 représente l'opération de dépôt. Le nuage se condense sur la surface qui lui est présentée et qui peut être soit la surface de la feuille de verre nue, soit une surface préalablement recouverte, par exemple d'une couche métallique 23 (figure 5).

Chaque électrode 80 est montée sur une barre 83 de façon à être suspendue en dessous de ladite barre. Le système de montage comprend une fente 82 ménagée dans la barre et une vis 81 retenue par la fente et pénétrant dans la cathode. La barre s'étend sur toute la largeur de la chambre, si bien que les bandes filtrantes peuvent être déposées comme indiqué précédemment. Une paire d'engrenages 86 dont un seul est représenté, sont fixés au bâti de l'enceinte, et maintiennent à leur tour les extrémités de la barre 83.

La barre est mobile dans une direction perpendiculaire à celle du déplacement de la feuille de verre 1, comme cela est indiqué par la flèche G. Par conséquent, on peut ajuster la distance entre les bandes filtrantes suivant les besoins.

Le mouvement de la barre 83 peut être un mouvement d'oscillation contrôlé par un moteur 85. A l'aide d'un engrenage 86, d'un arbre de transmission 87 et d'un écran 88 attachés à la barre 83, on transforme un mouvement de rotation en un mouvement d'oscillation. L'amplitude et la fréquence de l'oscillation dépendent de la forme que l'on souhaite donner aux couches filtrantes 52, 53, 54, et de la vitesse de déplacement de la feuille de verre 1. On peut fixer les paramètres à l'avance et les mettre en mémoire. Le système de mémorisation fait partie d'une unité de commande 90, reliée par une ligne 91 au moteur 85.

La figure 13 illustre une électrode 93 et une plaque 94 qui s'étendent sur toute la largeur de la chambre 29 pour former des bandes filtrantes 72, 73, 74 dont la largeur varie de façon périodique d'un bout à l'autre de la feuille de verre 1. Un écran analogue à l'écran 43 est placé en dessous de la plaque 94 pour obstruer certaines parties de la plaque et permettre à la matière en provenance des parties non obstruées de se déposer par condensation sur une surface. Comme précédemment, la surface peut être celle de la feuille de verre 1 nue ou déjà recouverte d'une couche métallique 23. Chaque écran est constitué d'une partie 95 et de deux parties supplémentaires 96, 97 situées au-dessus de la partie 95 de part et d'autre de ladite partie. Les parties latérales 96 et 97 sont mobiles par rapport à la partie centrale 95 pour fixer la largeur des bandes filtrantes sur toute la longueur de la feuille de verre 1. Ce mouvement, qui s'effectue dans des sens opposés, est symbolisé par la double flèche G''.

Chaque partie centrale 95 d'un écran est fixée à une barre 99. Plus précisément, elle est supportée par une console attachée à la barre par une pluralité de vis 98. Les vis sont mobiles dans une fente ménagée dans la console, de sorte que l'on peut ajuster la position de ladite partie centrale 95 par rapport à la barre et à la feuille de verre 1.

Les parties latérales 96, 97 de chaque écran sont montées sur un arbre 100 comprenant une succession de sections 101 dont les filetages sont alternativement droit et gauche. De cette façon, on peut contrôler chaque partie latérale pour qu'elles suivent simultanément un mouvement produisant un élargissement ou un rétrécissement des bandes de façon symétrique par rapport à la ligne centrale. Le mouvement de rotation de l'arbre 100 est transformé en un mouvement oscillatoire de sens opposé communiqué aux parties latérales grâce à une paire d'écrans 103, 104 portés par lesdites parties latérales 96, 97.

Il est possible de régler légèrement la position des parties latérales 96, 97. Ce réglage peut être effectué par la modification de dispositif décrite ci-après: les écrans 103, 104 sont formés de deux parties, une partie supérieure 107 et une partie inférieure 106. La partie inférieure de chaque écran est attachée à une partie latérale 96 (respectivement 97) de l'écran, et on utilise une ou plusieurs vis 108 pour assembler et détacher les parties. Quand les parties supérieure et inférieure sont détachées, on peut régler les parties latérales 96, 97.

Toutes les parties latérales 96, 97 des écrans sont déplacées simultanément le long de l'arbre 100. Un moteur 85 entraîne l'arbre par l'engrenage 86. Comme indiqué précédemment, la fréquence et l'amplitude des oscillations des parties latérales 96, 97 des écrans sont contrôlées par un système de commande numérique dans une unité de contrôle.

L'appareillage de la figure 14 peut, comme celui de la figure 13, déposer des bandes filtrantes dont la largeur varie périodiquement d'un bout à l'autre de la longueur de la feuille de verre 1. Il se différencie de la variante précédente dans la mesure où chaque paire 96, 97 de chaque écran est entraînée par des arbres individuels 110. Chaque arbre comprend une section (environ la moitié de la longueur totale) présentant un filetage droit 111 et une section présentant un filetage gauche 112. Chaque arbre peut être mis séparément en rotation par un moteur 114 suivant un programme déterminé. Puisque chaque moteur 114 peut être commandé par un programme indépendant, l'appareillage de la figure 14 permet de déposer sur la feuille de verre 1 toute une série de bandes filtrantes de formes diverses. On peut ainsi fabriquer un vitrage 8 muni de bandes filtrantes dont l'allure respective est différente.

## Revendications

1. Procédé pour la fabrication d'un vitrage, notamment de véhicule automobile, présentant une bande filtrante sur l'un au moins de ses bords périphériques, caractérisé en ce qu'on crée un mouvement relatif continu entre un panneau de verre de grandes dimensions et un dispositif, enfermé dans une enceinte convenant pour le dépôt de couches sur ledit panneau, la taille dudit panneau étant telle qu'il puisse être séparé en ébauches à partir desquelles seront découpés des vitrages de dimensions déterminées, on dépose les couches sous la forme d'une série de bandes filtrantes placées les unes à côté des autres et s'étendant de façon continue dans une direction du panneau de verre, on sépare le panneau de telle façon que chaque vitrage dont le contour est inscrit dans l'ébauche présente sur l'un au moins de ses bords périphériques un segment d'une bande filtrante continue.

2. Procédé selon la revendication 1, dans lequel chaque bande filtrante confère au vitrage des propriétés améliorées d'absorption et/ou de réflexion dans le domaine visible du spectre, et dans lequel on effectue le dépôt de ladite série de bandes filtrantes à l'aide d'un procédé de décomposition pyrolytique ou d'un procédé sous vide tel que l'évaporation thermique ou la pulvérisation cathodique.

3. Procédé selon la revendication 1, caractérisé en ce que les bandes filtrantes appartenant à une même série sont parallèles les unes aux autres.

4. Procédé selon la revendication 1, caractérisé en ce qu'on donne aux bandes filtrantes l'allure d'une succession continue de sections de courbes.

5. Procédé selon la revendication 4, caractérisé en ce que l'allure des courbes est celle d'un arc reproduit périodiquement.

6. Procédé selon la revendication 4, caractérisé en ce que l'allure des courbes est celle d'une sinusoïde.

7. Procédé selon l'une des revendications 4 à 6, caractérisé en ce qu'on prévoit un contour de vitrage dont le bord périphérique supérieur ou inférieur est non rectiligne, et on donne aux bandes filtrantes une allure telle que la ligne définissant sur le vitrage la limite entre la bande filtrante et la zone de vision suive le bord périphérique non rectiligne du vitrage.

8. Procédé selon l'une des revendications 4 à 7, caractérisé en ce qu'une série de bandes filtrantes comprend au moins quatre bandes, dont deux sur les bords dudit panneau et au moins deux centrales, les bandes centrales ayant une largeur constante sur toute leur longueur.

9. Procédé selon la revendication 4, caractérisé en ce que l'allure des courbes est telle que les bandes filtrantes présentent périodiquement des parties alternativement larges et resserrées.

10. Procédé selon l'une des revendications 1, 3 ou 4, caractérisé en ce que chaque bande filtrante intermédiaire située à distance des bords périphériques du panneau de verre a une largeur telle que lors de la séparation et découpe du panneau en ébauches, elle serve simultanément à deux vitrages distincts.

11. Procédé selon la revendication 1, caractérisé en ce qu'avant le dépôt d'une série de bandes filtrantes, on forme directement sur le panneau de verre au moins une couche de matière lui conférant, sur la partie non recouverte des bandes filtrantes, une très grande transparence dans le domaine visible du spectre et, corrélativement, une faible capacité d'émission et une forte capacité de réflexion dans le domaine infrarouge.

12. Procédé selon la revendication 11 dans lequel la couche de matière possède une bonne conductivité électrique.

13. Procédé selon la revendication 12 dans lequel la matière constitutive de la série de bandes filtrantes possède une conductivité électrique supérieure à celle de ladite couche de matière.

14. Procédé selon la revendication 10, caractérisé en ce que la largeur desdites bandes filtrantes intermédiaires est déterminée de façon à ce que dans chaque vitrage, la largeur de la bande filtrante supérieure et celle de la bande filtrante inférieure soient sensiblement identiques.

15. Procédé selon la revendication 1, caractérisé en ce qu'on dépose les bandes filtrantes appartenant à une même série de façon à ce que leur capacité de transmission dans le domaine du visible augmente de façon continue au fur et à mesure que l'on se rapproche de la ligne qui pour chaque bande définit la frontière avec la zone du panneau de verre non recouverte.

16. Procédé selon la revendication 11, caractérisé en ce que ladite couche de matière est choisie parmi le cuivre, l'aluminium, l'argent, le fer, le chrome, et l'or, et en ce que ladite couche et les bandes filtrantes sont des couches de même nature, intermédiaires entre une couche d'adhérence et une couche de protection, lesquelles peuvent être des composés métalliques ou semiconducteur, choisis parmi l'oxyde d'étain, l'oxyde d'indium et d'étain, le sulfure de zinc, l'oxyde de titane et le nitrure de titane.

17. Dispositif pour la mise en œuvre du procédé selon la revendication 1, comprenant un convoyeur horizontal pour déplacer continûment le panneau de verre et l'amener dans un bâti comprenant au moins une enceinte de dépôt et un système d'écluses disposé sur la trajectoire du panneau avant la première enceinte de dépôt et après la dernière enceinte de dépôt, pour permettre l'ouverture et la fermeture des enceintes maintenues sous vide, caractérisé en ce qu'au moins une enceinte de dépôt comprend un système d'électrode de pulvérisation cathodique disposé transversalement à la direction de déplacement du panneau de verre et servant à déposer simultanément des bandes filtrantes sur ledit panneau de verre.

18. Dispositif conforme à la revendication 17, caractérisé en ce que l'enceinte pour le dépôt des bandes filtrantes comprend une seule électrode qui s'étend sur toute la largeur du panneau de verre, des écrans étant disposés en dessous de l'électrode pour permettre le dépôt de bandes filtrantes dont la largeur correspond à l'intervalle situé entre deux écrans adjacents.

19. Dispositif selon la revendication 17, caractérisé en ce qu'il comprend une pluralité d'électrodes de pulvérisation, des moyens de support desdites électrodes et des moyens de réglage desdites électrodes les unes par rapport aux autres sur lesdits moyens de support.

20. Dispositif selon la revendication 19, caractérisé en ce qu'il comprend des écrans associés à chaque électrode de pulvérisation cathodique et des moyens de réglage desdits écrans pour modifier la largeur d'une bande filtrante appartenant à une même série de bandes filtrantes.

21. Dispositif selon la revendication 19, caractérisé en ce qu'il comprend des moyens supplémentaires permettant d'agir sur lesdites électrodes, lesdits moyens étant reliés à chaque électrode de pulvérisation cathodique pour permettre un changement périodique de position desdites électrodes par rapport à leurs moyens de support.

22. Dispositif selon la revendication 21, caractérisé en ce que lesdits moyens supplémentaires comprennent une barre, un moteur d'entraînement et un arbre d'entraînement relié audit moteur et à ladite barre.

23. Dispositif selon la revendication 21, caractérisé en ce que lesdits moyens supplémentaires sont commandés par un système de commande numérique suivant un programme déterminé à l'avance.

24. Dispositif selon la revendication 21, caractérisé en ce que les moyens supplémentaires agissent sur lesdites électrodes de pulvérisation de façon indifférenciée.

25. Dispositif selon la revendication 21, caractérisé en ce que lesdits moyens agissent individuellement sur chaque électrode de pulvérisation.

26. Dispositif selon l'une des revendications 18 et 20, caractérisé en ce que les écrans présentent un bord biseauté.

## Claims

1. Process for the production of a window, particularly for a car, having a filtering strip on at least one of its peripheral edges, characterized in that a continuous relative movement is produced between a large glass panel and an apparatus enclosed in an enclosure appropriate for the deposition of coatings on said panel, the size of the panel being such that it can be subdivided into blanks from which will be cut windows having clearly defined dimensions, the coatings are deposited in the form of a series of filtering strips, which are juxtaposed and extend continuously in one direction of the glass panel, the panel being separated in such a way that each window, whose contour is inscribed in the blank, has on at least one of its peripheral edges a segment of a continuous filtering strip.

2. Process according to claim 1, wherein each filtering strip gives the window improved absorption and/or reflection properties in the visible range of the spectrum and wherein the deposition of said series of filtering strips takes place with the aid of a pyrolytic decomposition process or a vacuum process, such as thermal evaporation or cathodic sputtering.

3. Process according to claim 1, characterized in that the filtering strips belonging to a same series are parallel to one another.

4. Process according to claim 1, characterized in that the filtering strips are in the form of a continuous succession of curved sections.

5. Process according to claim 4, characterized in that the configuration of the curves is that of a periodically reproduced arc.

6. Process according to claim 4, characterized in that the configuration of the curves is that of a sinusoid.

7. Process according to any one of the claims 4 to 6, characterized in that a window contour is provided, whose upper or lower peripheral edge is non-rectilinear and the filtering strips are given a configuration such that the line defining on said window the limit between the filtering strip and the vision area follows the non-rectilinear peripheral edge of the window.

8. Process according to any one of the claims 4 to 7, characterized in that a series of filtering strips comprises at least four strips, two of which are on the edges of said panel and at least two are central, the central strips having a constant width over their entire length.

9. Process according to claim 4, characterized in that the configuration of the curves is such that the filtering strips periodically have alternately wide and narrow portions.

10. Process according to any one of the claims 1, 3 or 4, characterized in that each intermediate filtering strip located at a distance from the peripheral edges of the glass panel has a width such that during the separation and cutting of the panel into blanks, it simultaneously serves for two separate windows.

11. Process according to claim 1, characterized in that, prior to the deposition of a series of filtering strips, on the glass panel is formed directly at least one material layer giving it, on the uncovered part of the filtering strips, a very considerable transparency in the visible range of the spectrum and correlatively a low emission capacity and high reflection capacity in the infrared range.

12. Process according to claim 11, wherein the material layer has a good electrical conductivity.

13. Process according to claim 12, wherein the material constituting the series of filtering strips has an electrical conductivity greater than that of said material layer.

14. Process according to claim 10, characterized in that the width of said intermediate filtering strips is determined in such a way that in each window, the width of the upper filtering strip and that of the lower filtering strip are substantially the same.

15. Process according to claim 1, characterized in that the filtering strips belonging to a same series are deposited in such a way that their transmission capacity in the visible range increases continuously on approaching the line which, for each strip, defines the boundary with the zone of the glass panel which is not covered.

16. Process according to claim 11, characterized in that said material layer is chosen from among copper, aluminium, silver, iron, chromium and gold and in that said layer and the filtering strips are layers of the same nature, intermediate between an adhesion layer and a protective layer, which can be metallic or semiconductor compounds, chosen from among tin oxide, indium and tin oxide, zinc sulphide, titanium oxide and titanium nitride.

17. Apparatus for performing the process according to claim 1, comprising a horizontal conveyor for continuously displacing the glass panel and bringing it into a frame having at least one deposition enclosure and a system of sluices or locks located on the path of the panel upstream of the first deposition enclosure and downstream of the final deposition enclosure, in order to permit the opening and closing of the enclosures maintained under vacuum, characterized in that at least one deposition enclosure comprises a cathodic sputtering electrode system arranged transversely to the displacement direction of the glass panel and used for simultaneously depositing filtering strips on said glass panel.

18. Apparatus according to claim 17, characterized in that the enclosure for the deposition of the filtering strips comprises a single electrode extending over the entire width of the glass panel, screens being placed above the electrode to permit the deposition of the filtering strips, whose width corresponds to the gap between two adjacent screens.

19. Apparatus according to claim 17, characterized in that it comprises a plurality of sputtering electrodes, support means for said electrodes and means for regulating said electrodes with respect to one another on said support means.

20. Apparatus according to claim 19, characterized in that it comprises screens associated with each cathodic sputtering electrode and means for regulating said screens in order to modify the width of a filtering strip belonging to a same series of filtering strips.

21. Apparatus according to claim 19, characterized in that it comprises supplementary means making it possible to act on said electrodes, said means being connected to each cathodic sputtering electrode to permit a periodic position change of said electrodes with respect to their support means.

22. Apparatus according to claim 21, characterized in that said supplementary means comprise a bar, a drive motor and a drive shaft connected to said motor and said bar.

23. Apparatus according to claim 21, characterized in that said supplementary means are controlled by a digital control system on the basis of a predetermined program.

24. Apparatus according to claim 21, characterized in that the supplementary means act in a random manner on said sputtering electrodes.

25. Apparatus according to claim 21, characterized in that said means act individually on each sputtering electrode.

26. Apparatus according to either of the claims 18 and 20, characterized in that the screens have a bevelled edge.

## Patentansprüche

1. Verfahren zur Herstellung einer Glasscheibe, insbesondere einer Autoglasscheibe, mit einem Filterband an wenigstens einer der Umfangskanten, dadurch gekennzeichnet, daß eine kontinuierliche Relativbewegung zwischen einer Glasplatte großer Abmessungen und einer in einem Gehäuse eingeschlossenen und für die Aufbringung von Schichten auf die Glasscheibe geeigneten Vorrichtung erzeugt wird, wobei die Größe der Glasplatte so bemessen ist, daß sie in Einzelglasscheiben unterteilt werden kann, aus denen Glasscheiben bestimmter Abmessungen herausgeschnitten werden, daß die Schichten in Form einer Reihe von nebeneinander angeordneten und sich kontinuierlich in einer Richtung der Glasscheibe erstreckenden Filterstreifen aufgebracht werden, und daß die Glasplatte so unterteilt wird, daß jede Glasscheibe, deren Kontur innerhalb einer Einzelglasscheibe liegt, an wenigstens einer ihrer Umfangskanten ein Segment eines kontinuierlichen Filterbandes aufweist.

2. Verfahren nach Anspruch 1, bei dem jedes Filterband der Glasscheibe verbesserte Absorptions- und/oder Reflexionseigenschaften im sichtbaren Bereich des Spektrums verleiht, und bei dem das Aufbringen der Reihe von Filterstreifen mit Hilfe eines Verfahrens der pyrolythischen Zersetzung oder eines Vakuumverfahrens, wie der thermischen Aufdampfung oder der Kathodenzerstäubung, erfolgt.

3. Verfahren nach Anspruch 1, dadurch gekennzeichnet, daß die jeweils zur derselben Reihe gehörenden Filterstreifen parallel zueinander verlaufen.

4. Verfahren nach Anspruch 1, dadurch gekennzeichnet, daß den Filterstreifen der Verlauf einer zusammenhängenden Aufeinanderfolge von Kurvenabschnitten erteilt wird.

5. Verfahren nach Anspruch 4, dadurch gekennzeichnet, daß der Verlauf der Kurven derjenige eines sich periodisch wiederholenden Bogens ist.

6. Verfahren nach Anspruch 4, dadurch gekennzeichnet, daß der Verlauf der Kurven derjenige einer Sinuskurve ist.

7. Verfahren nach einem der Ansprüche 4 bis 6, dadurch gekennzeichnet, daß eine Glasscheibenkontur vorgesehen wird, deren obere oder untere Umfangskante nicht geradlinig ist, und daß den Filterstreifen ein solcher Verlauf erteilt wird, daß die Linie, die auf der Glasscheibe die Grenze zwischen dem Filterband und der Sichtzone darstellt, der nicht geradlinigen Umfangskante der Glasscheibe folgt.

8. Verfahren nach einem der Ansprüche 4 bis 7, dadurch gekennzeichnet, daß eine Reihe von Filterstreifen wenigstens vier Streifen umfaßt, von denen zwei entlang den Kanten der Glasscheibe verlaufen und wenigstens zwei mittlere Streifen vorgesehen sind, wobei die mittleren Streifen eine konstante Breite auf ihrer ganzen Länge aufweisen.

9. Verfahren nach Anspruch 4, dadurch gekennzeichnet, daß der Verlauf der Kurven so gestaltet ist, daß die Filterstreifen periodisch abwechselnd breite und eingeschnürte Bereiche aufweisen.

10. Verfahren nach einem der Ansprüche 1, 3 oder 4, dadurch gekennzeichnet, daß jeder im Abstand von den Umfangskanten der Glasplatte angeordnete mittlere Filterstreifen eine solche Breite hat, daß er während der Aufteilung und des Schneidens der Glasplatte in Einzelglasscheiben gleichzeitig für zwei verschiedene Glasscheiben dient.

11. Verfahren nach Anspruch 1, dadurch gekennzeichnet, daß vor dem Aufbringen einer Reihe von Filterstreifen unmittelbar auf der Glasplatte wenigstens eine Materialschicht aufgebracht wird, die der Glasplatte auf dem nicht von den Filterstreifen bedeckten Teil eine sehr hohe Transparenz im sichtbaren Bereich des Spektrums und in Verbindung damit eine niedrige Emissivität und eine hohe Refexion im Infrarotbereich erteilt.

12. Verfahren nach Anspruch 11, bei dem die Materialschicht eine gute elektrische Leitfähigkeit aufweist.

13. Verfahren nach Anspruch 12, bei dem die die Reihe der Filterstreifen bildende Schicht eine elektrische Leitfähigkeit aufweist, die größer ist als diejenige der genannten Materialschicht.

14. Verfahren nach Anspruch 10, dadurch gekennzeichnet, daß die Breite der mittleren Filterstreifen so bestimmt wird, daß die Breite des oberen Filterbandes und die Breite des unteren Filterbandes im wesentlichen gleich sind.

15. Verfahren nach Anspruch 1, dadurch gekennzeichnet, daß die zu einer Reihe gehörenden Filterstreifen so aufgebracht werden, daß ihre Transmission in sichtbaren Bereich kontinuierlich in dem Maße zunimmt, wie man sich der Linie nähert, die für jedes Filterband die Grenze zu der nicht bedeckten Zone der Glasplatte bildet.

16. Verfahren nach Anspruch 11, dadurch gekennzeichnet, daß die Materialschicht aus Kupfer, Aluminium, Silber, Eisen, Chrom oder Gold besteht, und daß diese Schicht und die Filterstreifen Schichten gleicher Art sind und zwischen einer Haftschicht und einer Schutzschicht angeordnet sind, die ihrerseits Metallverbindungen oder Halbleiter sind und aus Zinnoxid, Zinn-Indium-Oxid, Zinksulfid, Titanoxid oder Titannitrid bestehen.

17. Vorrichtung zur Durchführung des Verfahrens nach Anspruch 1, mit einem Horizontalförderer für die kontinuierliche Förderung der Glasplatte und ihren Transport in eine Anlage mit wenigstens einem Gehäuse für das Aufbringen und einem System von Schleusen, die auf dem Weg der Glasplatte vor dem ersten Gehäuse und hinter dem letzten Gehäuse für das Aufbringen angeordnet sind, um das Öffnen und das Schließen der unter Vakuum gehaltenen Gehäuse zu ermöglichen, dadurch gekennzeichnet, daß wenigstens ein Gehäuse für das Aufbringen ein System von Kathodenzerstäubungselektroden umfaßt, das quer zur Bewegungsrichtung der Glasplatte angeordnet ist und für das gleichzeitige Aufbringen der Filterstreifen auf der Glasplatte dient.

18. Vorrichtung nach Anspruch 17, dadurch gekennzeichnet, daß das Gehäuse für das Aufbringen der Filterstreifen eine einzelne Elektrode umfaßt, die sich über die gesamte Breite der Glasplatte erstreckt, und daß unterhalb der Elektrode Blenden angeordnet sind, um das Aufbringen von Filterstreifen zu ermöglichen, deren Breite dem Zwischenraum zwischen zwei benachbarten Blenden entspricht.

19. Vorrichtung nach Anspruch 17, dadurch gekennzeichnet, daß sie eine Mehrzahl von Zerstäubungselektroden, Haltevorrichtungen für diese Elektroden und Mittel für die Einstellung dieser Elektroden in Bezug zueinander auf den Haltevorrichtungen umfaßt.

20. Vorrichtung nach Anspruch 19, dadurch gekennzeichnet, daß sie Blenden umfaßt, die jeder Kathodenzerstäubungselektrode zugeordnet sind sowie Mittel zur Einstellung dieser Blenden, um die Breite eines zu einer Reihe von Filterstreifen gehörenden Filterstreifens zu verändern.

21. Vorrichtung nach Anspruch 19, dadurch gekennzeichnet, daß sie zusätzliche auf die Elektroden einwirkende Mittel umfaßt, die mit jeder Kathodenzerstäubungselektrode verbunden sind, um eine periodische Änderung der Stellung der Elektroden auf ihren Haltevorrichtungen zu ermöglichen.

22. Vorrichtung nach Anspruch 21, dadurch gekennzeichnet, daß die zusätzlichen Mittel eine Stange, einen Antriebsmotor und eine mit diesem Antriebsmotor und mit der Stange verbundene Antriebsspindel umfassen.

23. Vorrichtung nach Anspruch 21, dadurch gekennzeichnet, daß die zusätzlichen Mittel durch ein numerisches Steuerungssystem entsprechend einem vorher bestimmten Programm gesteuert werden.

24. Vorrichtung nach Anspruch 21, dadurch gekennzeichnet, daß die zusätzlichen Mittel auf die Zerstäubungselektroden in gleicher Weise wirken.

25. Vorrichtung nach Anspruch 21, dadurch gekennzeichnet, daß die zusätzlichen Mittel auf jede Zerstäubungselektrode unterschiedlich wirken.

26. Vorrichtung nach einem der Ansprüche 18 und 20, dadurch gekennzeichnet, daß die Blenden eine abgeschrägte Kante aufweisen.

**Fig. 1**

**Fig. 2**

Fig. 3

**Fig. 4**

*Fig. 5*

*Fig. 6*

Fig. 8

Fig. 7

Fig. 10

Fig. 11

Fig. 9

**Fig. 12**

EP 0 140 793 B1

**Fig. 13**

**Fig. 14**

EP 0 140 793 B1